# EUROPEAN PATENT APPLICATION

(11) **EP 2 573 813 A1**
(43) Date of publication of application: **27.03.2013**
(21) Application number: 12008455.3
(22) Date of filing: 31.08.2009
(51) Int. Cl.: H01L 27/142

(54) **Method of manufacturing a thin film solar cell with unit cells connected in series with a reduced number of patterning steps and corresponding device**

(30) Priority: 01.09.2008 KR 20080085820
(62) Divisional of application: 09810241.1
(71) Applicant: LG Electronics Inc., Yeongdeungpo-gu Seoul 150-721 (KR)
(72) Inventor: Kim, Sun Ho, 137-724 Seoul (KR); Choi, Jung Hoon, 137-724 Seoul (KR); Lee, Seung-Yoon, 137-724 Seoul (KR); Lee, Heon Min, 137-724 Seoul (KR); Eo, Young Joo, 137-724 Seoul (KR); Moon, Kang Seok, 137-724 Seoul (KR); Ahn, Seh-Won, 137-724 Seoul (KR)
(74) Representative: Katérle, Axel

(57) **Abstract**

Disclosed are a method for manufacturing a thin-film type solar cell with unit cells connected in series that uses a direct printing method and reduces the number of patterning processes and a thin-film type solar cell obtained thereby. The method may comprise: forming a lower transparent electrode layer (301), a semiconductor layer for photoelectric conversion (302) and an upper transparent electrode layer (303) on a substrate (300); cutting through portions of the lower transparent electrode layer (301), the semiconductor layer for photoelectric conversion (302) and the upper transparent electrode layer (303), so that a plurality of cells are patterned, and portions of the substrate (300) and other portions of the lower transparent electrode layer (301) are exposed; forming an insulating layer (304) on the plurality of cells so that respective portions of the insulating layer (304) extend between a lower transparent electrode layer (301) and an upper transparent electrode layer (303) of each of the plurality of cells; and forming a rear electrode layer (305) on the plurality of cells so that respective portions of the rear electrode layer (305) extend to connect an upper transparent electrode layer (303) of one of the plurality of cells to a lower transparent electrode layer (301) of an adjacent another of the plurality of cells in series. Alternatively, the method may comprise: cutting through portions of a lower transparent electrode layer (401) formed on a substrate (400) to pattern the lower transparent electrode layer (401); sequentially forming a semiconductor layer for photoelectric conversion (402) and an upper transparent electrode layer (403) on the patterned lower transparent electrode layer (401); cutting through portions of the semiconductor layer for photoelectric conversion (402) and the upper transparent electrode layer (403), so that a plurality of cells are patterned, and portions of the lower transparent electrode layer (401) are exposed; and forming a rear electrode layer (404) on the plurality of cells so that respective portions of the rear electrode layer (404) extend to connect an upper transparent electrode layer (403) of one of the plurality of cells and a portion of an exposed lower transparent electrode layer (401) of an adjacent another of the plurality of cells in series.

## Description

### Technical Field

The present invention relates to a thin-film type solar cell and a method for manufacturing the same, and more specifically, to a method for manufacturing a thin-film type solar cell having high photoelectric conversion efficiency while reducing process costs by reducing a frequency of a patterning process. Further, the present invention relates to a method for manufacturing a thin-film type solar cell in which a rear electrode layer is simply formed using a direct printing method in the process of sequentially forming a lower transparent electrode layer, a semiconductor layer for photoelectric conversion, and an upper transparent electrode layer on a substrate and forming each rear electrode layer after patterning into a plurality of cells.

### Background Art

Recently, eco-friendly alternative energy is getting more and more interest due to an earth environment problem and a resource depletion problem. Under this situation, one of technologies in which people are focusing attention is a photovoltaic generation technology. A solar cell to generate electricity using sunlight has generally been manufactured using silicon. Currently commercialized bulk silicon solar cells have not entered into widespread use due to high manufacturing costs and installation costs. In order to solve such problems related to the cost, research into a thin-film type solar cell using silicon has activelyprogressed and various attempts to manufacture a high efficiency solar cell module have been made.

The solar cell is a next-generation clean energy source and much research thereinto has been underway for several decades. As materials used for the solar cell, materials of group IV, such as single crystal silicon, polycrystalline silicon, amorphous silicon, amorphous SiC, amorphous SiN, amorphous SiGe, amorphous SiSn, etc., and compound semiconductors of group III-V, such as GaAs, AlGaAs, InP, etc. or group II-VI of CdS, CdTe, Cu₂S , etc. have been used.

Generally, a solar cell should have the following characteristics: high photoelectric conversion efficiency, low manufacturing costs, short energy recovery period, etc. In particular, since a reduction in process frequency is economically useful in terms of the manufacturing costs of the solar cell, research into this field has actively progressed.

### Disclosure of Invention

### Technical Problem

Accordingly, it is an object of the present invention to provide a thin-film type solar cell having high photoelectric conversion efficiency by a relatively simple process and a method for manufacturing solar cell devices at low manufacturing costs, in a thin-film type solar cell.

In particular, it is another object of the present invention to provide a method for manufacturing solar cell devices capable of reducing a patterning frequency to minimize a dead area occurring in a patterning process, thereby improving efficiency and removing metal electrode residues to improve process reliability.

### Technical Solution

In order to achieve the objects, there is provided a method for manufacturing a thin-film solar cell including sequentially forming a lower transparent electrode layer, a semiconductor layer for photoelectric conversion, and an upper transparent electrode layer on a substrate; cutting through portions of the lower transparent electrode layer, the semiconductor layer for photoelectric conversion, and the upper transparent electrode layer, so that a plurality cells are patterned, and portions of the substrate and other portions of the lower transparent electrode layer are simultaneously exposed; forming an insulating layer on the plurality of cells so that respective portions of the insulating layer extend between a lower transparent electrode layer and an upper transparent electrode layer of each of the plurality of cells; and forming a rear electrode layer on the plurality of cells so that respective portions of the rear electrode layer extend to connect an upper transparent electrode layer of one of the plurality of cells to a lower transparent electrode layer of an adjacent another of the plurality of cells in series.

There is also provided a method for manufacturing a thin-film solar cell, including cutting through portions of a lower transparent electrode layer formed on a substrate to pattern the lower transparent electrode layer; sequentially forming a semiconductor layer for photoelectric conversion and an upper transparent electrode layer on the patterned lower transparent electrode layer; cutting through portions of the semiconductor layer for photoelectric conversion and the transparent electrode layer to pattern a plurality of cells and to expose other portions of the lower transparent electrode layer; and forming a rear electrode layer on the plurality of cells so that respective portions of the rear electrode extend to connect an upper transparent electrode layer of one of the plurality of cells and a portion of an exposed lower transparent electrode layer of an adjacent another of the plurality of cells in series.

There is also provided a thin-film solar cell including a plurality of cells, the thin-film solar cell including a substrate; and a lower transparent layer, a semiconductor layer for photoelectric conversion, an upper transparent layer, and a rear electrode layer that are sequentially formed on the substrate, wherein respective portions of the rear electrode layer extend from an upper surface of the upper transparent electrode layer of one of the plurality of cells to a lower transparent electrode layer of an adjacent another of the plurality of cells in series.

In the manufacturing process of a solar cell according to the related art, a portion lost by the cutting process is 100 m or more. However, the method for manufacturing a solar cell according to the present invention reduces the frequency of the cutting process to increase the cost reducing effect in terms of manufacturing costs and provide a solar cell through simpler process. In other words, in manufacturing the thin-film type solar cell, the manufacturing method according to the related art needs to perform the cutting process numerous times. However, the present invention reduces the cutting process over the related art, as well as similar processes are simultaneously performed to unify the process to promote simplification and unification in terms of the manufacturing process, making it possible to manufacture the thin-film type solar cell with reduced manufacturing costs.

### Advantageous Effects

According to the present invention, the thin-film type solar cell can be manufactured at one time through a series of manufacturing processes that results in high photoelectric conversion efficiency and is relatively simple. Further, the present invention can manufacture the solar cell by reducing the frequency of patterning and the process costs.

The present invention proposes the structure and method for manufacturing the solar cell that has the high photoelectric conversion efficiency and can be manufactured at a reduced process costs. As a result, when the present invention is commercialized, the commercialized solar cell as the next-generation clean energy source contributes to the earth environment as well as may be directly applied for various fields such as public facilities, private facilities, military facilities, etc., making it possible to create a huge economic value.

### Brief Description of Drawings

The above objects, features and advantages of the present invention will become more apparent to those skilled in the art in conjunction with the accompanying drawings. In the drawings:

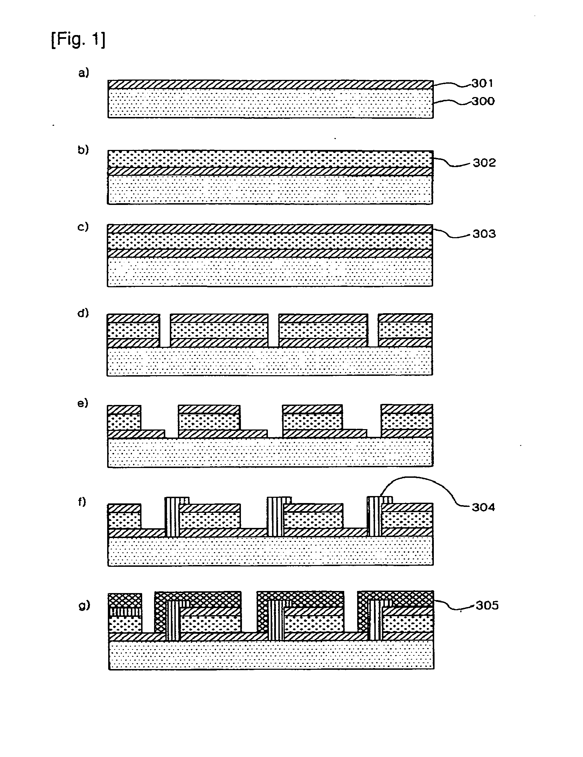

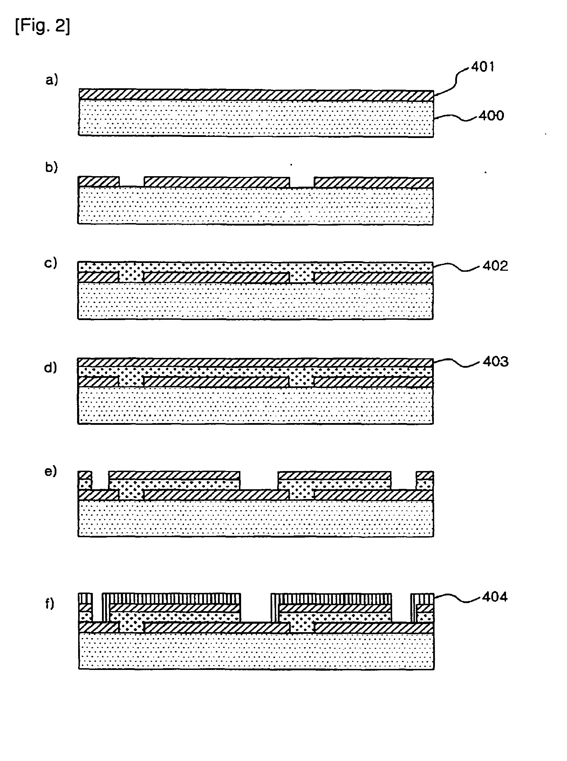

FIGS. 1 and 2 are cross-sectional views of a structure of a solar cell showing a method for manufacturing a thin-film type solar cell according to one embodiment of the present invention by each process, respectively.

### Best Mode for Carrying out the Invention

Hereinafter, example embodiments of the present invention will be described in detail with reference to the accompanying drawings. In referring to reference numerals to components of each drawing, the same components are referred to by the same reference numerals as much as possible even if they are shown in different figures. Detailed descriptions of well-known techniques are omitted so as not to obscure the description of the present invention with unnecessary detail.

FIG. 1 is a cross-sectional view of a stacking structure of devices showing a method for manufacturing a thin-film type solar cell according to one embodiment of the present invention by each process. The following processes are only one example embodiment and may not be limited to this particular sequence.

The processes will be described in detail with reference to FIG. 1. Step (a) is an initial step for manufacturing a thin-film type solar cell of the present invention. In detail, a lower transparent electrode layer 301 is deposited on a substrate 300.

In step (b), a semiconductor layer 302 for photoelectric conversion is deposited on the lower transparent electrode layer 301. As materials used for the semiconductor layer 302 for photoelectric conversion, semiconductor materials, that convert light energy into electric energy, can be used. For example, any one may be selected from a group consisting of amorphous silicon, microcrystalline silicon, single crystal silicon, polysilicon, amorphous SiC, amorphous SiN, amorphous SiGe, amorphous SiSn, gallium arsenide (GaAs), aluminum gallium arsenide (AIGaAs), indium phosphide (InP), gallium phosphide (GaP), Copper Indium Gallium Selenide (CIGS), cadmium telluride (CdTe), cadmium sulfide (CdS), copper(I) sulfide (Cu₂S), zinc telluride (ZnTe), lead sulphide (PbS), copper indium diselenide (CulnSe_{2;}CIS), gallium-antimonide(GaSb), and compounds thereof.

In step (C), an upper transparent electrode layer 303 is deposited on the semiconductor layer 302 for photoelectric conversion.

In step (d), portions of the lower transparent electrode layer 301, the semiconductor layer 302 for photoelectric conversion, and the upper transparent electrode layer 303 are cut through so that portions of the substrate 300 are exposed. The solar cell is divided into a plurality of solar cells (unit cells, or unit solar cells) by the cutting process.

The lower transparent electrode layer 301 and the upper transparent electrode layer 303 are referenced according to the positions they occupy in each of the stacked solar cell devices shown in a cross-sectional view for convenience sake. They can be deposited using the same materials and methods. They can be deposited by a known deposition method using materials usable as a conductive layer known to those skilled in the art. In particular, tin oxide (SnO₂) and indium tin oxide (ITO), which are materials having good conductivity, are preferably used.

Further, the cutting process in the related art known to those skilled in the art can be used. Generally, the cutting process can be any one of an optical scribing method, a mechanical scribing method, a plasma based etching method, a wet etching method, a dry etching method, a lift-off method, and/or a wire mask method.

Meanwhile, as the optical scribing method, a laser scribing method is mainly used. The laser scribing method is a method that diagonally scans laser light with respect to a substrate and processes a thin film on the substrate.

Next, in step (e), the laser scribing on the semiconductor layer 302 for photoelectric conversion and the upper transparent electrode layer 303 is performed so that a portion of the lower transparent electrode layer 301 is exposed. In steps (d) and (e), the continuous cutting is performed, such that a hard scribing technology can be smoothly performed.

The size of the exposed substrate and the lower transparent electrode layer is not limited, but the size will be enough to classify or delineate the plurality of solar cells.

In step (f), an insulating layer 304 is directly printed on the lower transparent electrode layer 301 in a cell unit, and side exposed parts of the semiconductor layer 302 for photoelectric conversion and the upper transparent electrode layer 303 to isolate each of the plurality of solar cells.

A direct printing method used in the present invention may include a screen printing method, an offset lithography printing method, an inkjet printing method, a roll-to-roll method, etc. The thin-film type solar cell can be mass produced by these technologies.

Meanwhile, the screen printing method, which is a non-pressing printing method using stencil, has an advantage in that ink and the substrate are not affected. As a result, it is appropriate for thickly depositing ink on a large-area substrate. Further, the screen printing method is a technology that can perform a thin film forming process and a patterning process in the atmosphere at one time.

The offset lithography printing method, which is a process technology that can print various kinds of materials, is a technology using a suction condition arising from a substrate surface energy.

The inkjet printing method, which is a technology that forms fine ink drops and patterns them on desired positions on the substrate and is a non-contact scheme, is suitable for implementing a complicated shape in a small volume.

Additionally, the insulating layer 304 is composed of one or more materials selected from a group consisting of an oxide and a nitride.

In step (g), a rear electrode layer 305 is directly printed on the plurality of cells to connect the upper transparent layer 303 and a portion of the exposed lower transparent electrode layer 301 in series. Through this process, the divided cells are connected to each other in series by the rear electrode layer 305 to form a solar cell module on the substrate. In other words, the cells are connected to each other while (or by) forming the rear electrode layer 305 of the cell.

The rear electrode layer 305 can be also processed in simpler and easier processes using the direct printing method as described above.

In other words, the rear electrode layer 305 composed of metallic materials such as aluminum, etc., can be easily formed by the screen printing method, the offset lithography printing method, the inkjet printing method, the roll-to-roll method, etc., such that the solar cell can be mass produced, making it possible to obtain an effect of cost reduction.

The rear electrode layer 305 can be formed using the materials that can generally be used for the electrode layer and methods, which are known to those skilled in the art. In particular, a metal layer composed of aluminum (Al), silver (Ag), titanium (Ti), palladium (Pd), etc., is manufactured using the screen printing method. Generally, the manufacturing of the metal layer uses a method that performs the screen printing with Ag paste, stabilizes it, dries it in an oven, and then performs heat treatment thereon.

The method for manufacturing a thin-film type solar cell according to one embodiment of the present invention as described above has a process in that the printing process should be performed twice, but has an advantage in that after all the deposition processes are performed from the lower transparent electrode layer, the scribing process and the printing process can be performed separately.

The thin-film type solar cell manufactured using the method for manufacturing a solar cell of FIG. 1 is configured of the plurality of unit cells divided by the patterning and these unit cells are electrically connected to each other by the transparent conductive layers formed on upper and lower portions of the photoelectric conversion layer of each solar cell. The plurality of unit cells are electrically connected to each other in series, making it possible to configure an integrated thin-film type solar cell.

Upon connecting the unit cells in series, the insulating layer 304 is disposed between the unit cells, which prevents the upper and lower transparent electrode layers 303, 301 inside one unit solar cell from electrically connecting each other, and can connect the upper and lower transparent electrode layers 303, 301 to the adjacent unit solar cells in series.

In other words, in one embodiment of the present invention, the thin-film type solar cell is patterned into the plurality of cells by sequentially performing the cutting process on the upper transparent electrode layer 303, the semiconductor layer 302 for photoelectric conversion, and the lower transparent electrode layer 301 from the top. The insulating layer 304 is formed between the plurality of cells and the rear electrode layer 305 is formed thereon, making it possible to form a structure where the adjacent unit cells are electrically connected to each other.

FIG. 2 is a cross-sectional view of a stacking structure of devices which shows a method for manufacturing a thin-film type solar cell according to one embodiment of the present invention by each process.

The processes will be described in detail with reference to FIG. 2. Step (a) is an initial step for manufacturing a thin-film type solar cell of the present invention. In detail, a lower transparent electrode layer 401 is deposited on a substrate 400. The deposition process selected from the thin film deposition methods known to those skilled in the art can be used.

In step (b), the laser scribing on the lower transparent electrode layer 401 is performed so that a portion of the substrate 400 is exposed. In step (c), a semiconductor layer 402 for photoelectric conversion is deposited on the lower transparent electrode layer 401 that is subjected to the laser scribing.

The materials usable for the semiconductor layer 302 for photoelectric conversion as described above can also be used for the semiconductor layer 402 in the present embodiment.

In step (d), an upper transparent electrode layer 403 is deposited on the semiconductor layer 402 for photoelectric conversion. In step (e), the semiconductor layer 402 for photoelectric conversion and the upper transparent electrode layer 403 are cut so that a portion of the lower transparent electrode layer 401 is exposed. The plurality of unit solar cells can be formed through these cutting processes. The cutting process is the same as the foregoing embodiment.

The lower transparent electrode layer 401 and the upper transparent electrode layer 403 can use the same materials as the lower transparent electrode layer 301 and the upper transparent electrode layer 303 described in the foregoing embodiment.

In step (f), the direct printing is performed on the rear electrode layer 404 to connect the upper transparent electrode layer 403 of the predetermined cell and the lower transparent electrode layer 401 of a cell adjacent thereto in series. In other words, the cells are connected to each other while (or by) forming the rear electrode layer 404 of the cell.

The rear electrode layer 404 can use the same materials as the rear electrode layer 305 of the foregoing embodiment. The direct printing method is the same as the foregoing description.

The thin-film type solar cell manufactured through the method for manufacturing a solar cell shown in FIG. 2 is manufactured through a two-step process that saves the cutting process once, unlike the method for manufacturing a solar cell according to the related art. The thin film solar cell is patterned into the plurality of cells by sequentially performing a secondary cutting process on the upper transparent electrode layer 403 and the semiconductor layer 402 for photoelectric conversion from the top to meet the pattern. The rear electrode layer 404 is simply and easily formed on the plurality of cells by the direct printing method as in the embodiment of FIG. 1, such that the adjacent unit cells are electrically connected to each other.

The above embodiment controls the inter-layer structure by the patterning using the cutting process and the sequence of deposition within the manufacturing method according to the present invention, such that the above structure can be achieved without adding a separate process, thereby facilitating the manufacturing of the thin-film type solar cell. Further, the frequency of the cutting process is reduced as compared to the method for manufacturing a thin-film type solar cell according to the related art, such that the solar cell having high photoelectric conversion efficiency while reducing process costs can be manufactured.

Further, since the method for manufacturing a thin-film type solar cell according to one embodiment of the present invention as described above performs the scribing after the deposition of the lower transparent electrode layer and the deposition and scribing processes again, and then performs the printing, it has a process that is continuous but has an advantage in reducing the number of processes by performing the printing process once.

Although the present invention has been described in connection with the exemplary embodiments illustrated in the drawings, it is only illustrative. It will be understood by those skilled in the art that various modifications and equivalents can be made to the present invention. Therefore, the true technical scope of the present invention should be defmed by the appended claims.

## Claims

1. A method for manufacturing a thin-film solar cell, comprising:
cutting through portions of a lower transparent electrode layer formed on a substrate to pattern the lower transparent electrode layer;
sequentially forming a semiconductor layer for photoelectric conversion and an upper transparent electrode layer on the patterned lower transparent electrode layer;
cutting through portions of the semiconductor layer for photoelectric conversion and the transparent electrode layer, so that a plurality of cells are patterned, and
portions of the lower transparent electrode layer are exposed; and
forming a rear electrode layer on the plurality of cells so that respective portions of the rear electrode layer extend to connect an upper transparent electrode layer of one of the plurality of cells and a portion of an exposed lower transparent electrode layer of an adjacent another of the plurality of cells in series.

2. The method according to claim 1, wherein the rear electrode layer is formed by a direct printing method.

3. The method according to claim 2, wherein the direct printing method is any one of a screen printing method, an offset lithography printing method, and an inkjet printing method.

4. The method according to any one of claims 1 to 3, wherein a method for at least one of the two cutting through steps is at least one of a laser scribing method, a mechanical scribing method, a plasma based etching method, a wet etching method, a dry etching method, a lift-off method, and a wire mask method.

5. A thin-film solar cell including a plurality of cells, the thin-film solar cell comprising:
a substrate; and
a lower transparent layer, a semiconductor layer for photoelectric conversion, an upper transparent layer, and a rear electrode layer that are sequentially formed on the substrate, wherein respective portions of the rear electrode layer extend from an upper surface of the upper transparent electrode layer of one of the plurality of cells to a lower transparent electrode layer of an adjacent another of the plurality of cells in series, wherein portions of the substrate are exposed, and respective portions of the semiconductor layer for photoelectric conversion are provided in the respective exposed portions of the substrate between adjacent portions of the lower transparent electrode layer of the plurality of cells.
